**Europäisches Patentamt**

**European Patent Office**

**Office européen des brevets**

(19)

(11) Numéro de publication: **0 299 887 B1**

(12) **FASCICULE DE BREVET EUROPEEN**

(45) Date de publication de fascicule du brevet: **03.02.93**

(51) Int. Cl.⁵: **G01R 27/02**, H01L 29/06

(21) Numéro de dépôt: **88420237.5**

(22) Date de dépôt: **06.07.88**

(54) **Structure et procédé de test pour circuit intégré permettant la détermination des effets de surface de couches.**

(30) Priorité: **07.07.87 FR 8709903**

(43) Date de publication de la demande:
**18.01.89 Bulletin 89/03**

(45) Mention de la délivrance du brevet:
**03.02.93 Bulletin 93/05**

(84) Etats contractants désignés:
**DE FR GB IT NL**

(56) Documents cités:
**EP-A- 0 175 870**
**EP-A- 0 201 945**
**FR-A- 2 296 852**

**IBM TECHNICAL DISCLOSURE BULLETIN, vol. 14, no. 12, 12 mai 1972, page 3707, New York, US; T.H. BAKER et al.: "Dumbbell-type resistance testing structure"**

(73) Titulaire: **SGS-THOMSON MICROELECTRO-NICS S.A.**
**7, Avenue Galliéni**
**F-94250 Gentilly(FR)**

(72) Inventeur: **Juge, André**
**15, Rue de la Contamine**
**F-38120 Saint Egreve(FR)**

(74) Mandataire: **de Beaumont, Michel et al**
**1bis, rue Champollion**
**F-38000 Grenoble(FR)**

Rank Xerox (UK) Business Services

**Description**

Dans le domaine de la fabrication des circuits intégrés, on procède habituellement par traitement de lots de tranches semiconductrices, chaque circuit intégré occupant une petite surface, généralement rectangulaire, de chaque tranche. De multiples motifs identiques sont répétés sur la même tranche. Toutefois, pour pouvoir vérifier s'il n'y a pas eu de dérive au cours des procédés de fabrication par rapport aux paramètres préétablis, on prévoit généralement de laisser libres certains des rectangles formés dans le quadrillage de la tranche pour y insérer des motifs de test destinés à vérifier rapidement les caractéristiques propres à la tranche et au lot de fabrication particulier. Ces motifs de test peuvent servir à vérifier des paramètres de fonctionnement alors que la tranche est terminée, avant mise en boîtier, ou bien peuvent être utilisés pour effectuer des vérifications lors d'étapes intermédiaires du processus de fabrication, soit pour corriger des défauts existant au cours d'étapes préalables, soit pour décider du rejet de la tranche avant d'effectuer de trop nombreuses étapes sur celle-ci. En tout cas, les résultats de ce test sont utilisés pour déterminer un réglage particulier de paramètres lors du lot suivant devant théoriquement être traité par le même processus.

Parmi les paramètres importants que l'on souhaite déterminer, se trouvent les paramètres de conduction par unité de surface. En effet, souvent dans un circuit intégré, les diverses portions de couche interviennent en fonction de leurs caractéristiques surfaciques.

Les effets physiques participant à la conduction du courant dans les couches semiconductrices sont d'autant plus complexes que les dimensions dessinées de ces couches sont plus réduites. Au fur et à mesure que la surface des composants élémentaires (diodes, transistors, résistances) se réduit grâce aux progrès des technologies de fabrication, et notamment de la photolithographie, les effets physiques de surface (courant, capacités) s'accompagnent d'effets :
- périmétriques pour des motifs longilignes et étroits,
- de coins pour des motifs carrés.

D'autre part, un écart inévitable se produit lors de la réalisation de ces couches, entre le dessin des motifs et leur implantation sur silicium.

Cet écart dépend directement du procédé de fabrication. Il peut être positif ou négatif. Il est également dispersé en fonction des variations des paramètres de fabrication.

Cet écart intègre les imprécisions dans la réalisation de toutes les étapes d'un procédé donné, depuis la réalisation des masques (tolérances de positionnement), en passant par les niveaux de sélection (surgravures des résines dans le cas d'un masquage résine, extensions latérales d'oxyde dans les technologies LOCOS), et les étapes de diffusion ou implantation/recuit (diffusions latérales).

Il est fondamental dans tout procédé de fabrication de pouvoir identifier et séparer ces différents effets (surface, périmètre, coins) à la fois en valeur nominale et en dispersion ; et de pouvoir suivre leur évolution dans le temps. Dans ce but, les mesures physiques, par microscopie ou analyse dites "spreading resistance", permettent une détermination ponctuelle de ces phénomènes, mais sont trop lourdes pour envisager un suivi statistique.

L'utilisation d'un procédé de test électrique mis en oeuvre sur des motifs adaptés, permet une approche plus rapide et utilisable de ces phénomènes, car elle fournit des résultats qui intéressent directement les concepteurs de circuits.

Ces résultats sont présentés sous la forme de paramètres électriques unitaires liés à des considérations géométriques. On pratique couramment les unités suivantes :

| Grandeur électrique | Surface | Périmètre | Coins |
|---|---|---|---|
| Densités de courant | A/um$^2$ | A/um | A/coin |
| Capacités de jonctions ou d'oxyde | f/um$^2$ | f/um | f/coin |
| Charges de diffusion | C/um$^2$ | C/um | C/coin |
| (l'abréviation um désigne un micromètre) | | | |

Ces informations sont indispensables à la conception, car elles permettent l'optimisation du dessin des composants élémentaires (transistors, diodes,...) dans une technologie donnée, d'où un gain de temps et de coût considérable grâce au nombre d'essais de fabrication fortement réduit avant d'atteindre l'optimum désiré.

Par ailleurs, elles sont un outil d'analyse complémentaire pour les équipes chargées d'optimiser les processus de fabrication.

EP 0 299 887 B1

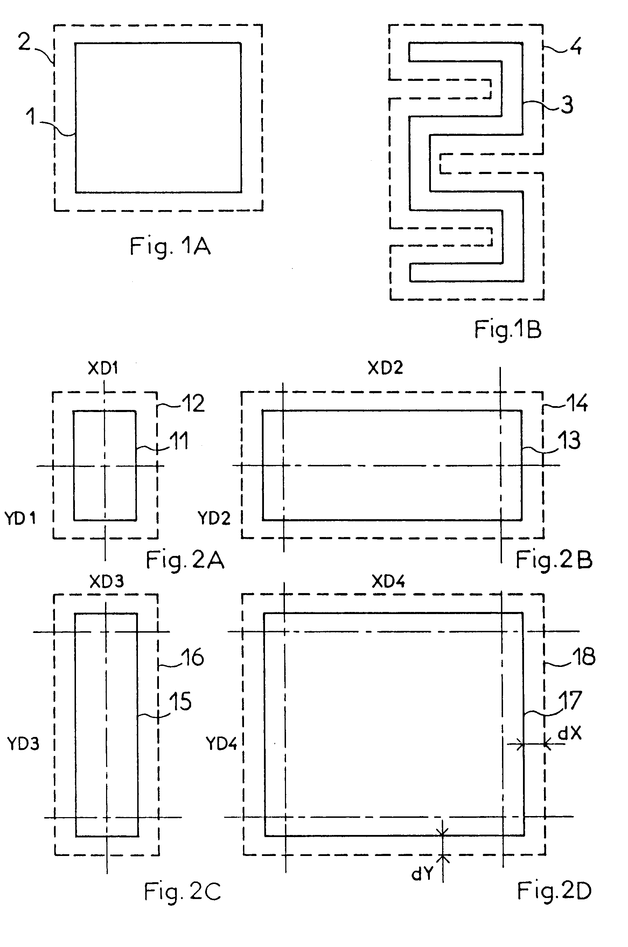

A l'heure actuelle, on utilise par exemple des motifs de test tels que ceux illustrés en figures 1A et 1B.

La figure 1A représente un premier motif de test. Dans cette figure, le cadre en trait plein 1 désigne le dessin d'un masque ayant servi à former ou à délimiter une couche et le cadre en traits pointillés 2 désigne le motif résultant de cette opération.

La figure 1B représente un deuxième motif de test associé au premier. De même, le cadre 3 représente un masque de formation de délimitation de couche et le cadre en pointillés 4 désigne la structure obtenue.

Les structures des figures 1A et 1B se caractérisent par le fait qu'elles ont des rapports périmètre/surface différents. Pour utiliser ces structures, on les incorpore dans un composant électrique élémentaire d'un circuit intégré (résistance, transistor, etc.), de manière qu'un courant soit amené à passer perpendiculairement auxdites couches. Dans de mêmes conditions d'application de tension, on mesure les courants I1 et I2 apparaissant aux bornes desdites couches, en continu ou en alternatif selon le type de structure. Ayant mesuré ces courants I1 et I2, et connaissant les surfaces dessinées SD1 et SD2 des deux motifs ainsi que les périmètres PD1 et PD2 de ces motifs, on détermine les densités de courant JS et JP respectivement associées aux effets de surface et de périmètre des deux structures par les formules suivantes :

$$JS \times SD1 \ + \ JP \times PD1 \ = \ I1$$
$$JS \times SD2 \ + \ JP \times PD2 \ = \ I2$$

On notera que pour écrire ces deux équations, on a négligé les effets de coins.

Ce procédé présente des inconvénients. En effet, on observe dans les résultats obtenus une imprécision importante qui a pour origine la non prise en compte des effets de coins. Cette imprécision rend inapplicable les résultats à l'optimisation du dessin des composants de petite dimension, où les effets de coins sont prépondérants. Par ailleurs, elle implique une erreur systématique et non évaluable a priori, dans le dessin des composants de grandes dimensions. Ce procédé ne permet pas non plus de différencier les effets en X et en Y d'un périmètre.

Un objet de la présente invention est de prévoir une nouvelle structure de motifs de test permettant de fournir par des calculs simples et rapides les densités de courant associées aux effets de surface, de périmètre en X, de périmètre en Y et de coins pour des portions de couche de circuit intégré.

Pour atteindre cet objet, la présente invention prévoit une structure de test de circuit intégré pour déterminer l'incidence de divers effets de conduction dans des couches données et séparer les effets de surface des effets de coin et de périmètre dans deux directions perpendiculaires dans laquelle des motifs de test de formes déterminées sont insérés dans des composants élémentaires comprenant lesdites couches polarisées dans le sens de leur épaisseur, comprenant au moins quatre motifs de test dans lesquels lesdites couches sont délimitées selon quatre rectangles dont chacun se déduit des autres par une dimension commune et que ces quatre rectangles n'ont que deux dimensions de longueur et deux dimensions de largeur.

Un procédé de test selon la présente invention comprend les étapes suivantes :

- connecter ensemble à une première borne les premiers contacts des composants associés à une première face des motifs de test ;
- connecter les autres contacts des composants associés à la deuxième face des motifs à une deuxième borne par l'intermédiaire de moyens de mesure d'un paramètre électrique ;
- appliquer entre les première et deuxième bornes une source d'alimentation électrique ;
- mesurer les flux de courant traversant chaque motif de test ;
- en déduire les effets de surface, de périmètre en X et en Y, et de coin.

Ces objets, caractéristiques et avantages ainsi que d'autres de la présente invention seront exposés plus en détail dans la description suivante de modes de réalisation particuliers faite en relation avec les figures jointes parmi lesquelles :

les figures 1A et 1B décrites précédemment étaient destinées à exposer les invonvénients de motifs de test selon l'art antérieur ;

les figures 2A à 2D représentent des motifs de test selon la présente invention ;

la figure 3 représente de façon extrêmement schématique un mode de connexion de motifs de test selon la présente invention pour permettre une mesure simple de paramètres de conduction surfacique des couches concernées ; et

les figures 4A et 4B représentent respectivement une vue de dessus et une vue en coupe d'un motif de test selon la présente invention incorporé dans un transistor NPN, constituant un mode de réalisation particulier de la présente invention.

Dans les figures 2A à 2D, on peut voir quatre dessins de masque 11 à 17 disposés en carré et les motifs réels résultants 12 à 18. Comme le montrent les figures, chacun des masques se déduit des deux masques adjacents par le fait qu'il possède les mêmes dimensions en X ou en Y. Ainsi, si pour chaque motif de masque on désigne par XD la dimension en X dessinée et par YD la dimension en Y dessinée, on a XD1 = XD3, XD2 = XD4, YD1 = YD2 et YD3 = YD4. On notera que :

- Chacun des motifs présente des effets de surface, périmètres et coins avec une pondération différente dans le phénomène global observé (courant vertical ou capacité de charge).
- Les surfaces et périmètres réels de chaque motif après fabrication sont différents des surfaces et périmètres dessinés ; ces écarts sont, a priori, indéterminés.
- L'hypothèse de couche mince est vérifiée, c'est-à-dire que la profondeur XJ de la couche considérée reste petite par rapport à la longueur et la largeur du motif minimum (environ 10 % de la plus petite de ces dimensions ou moins).

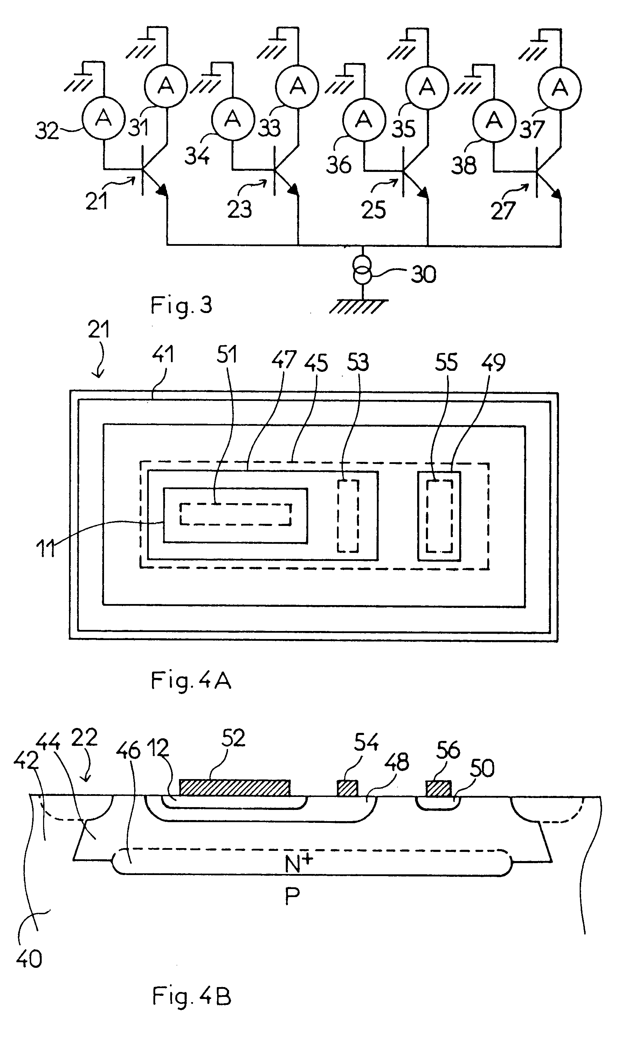

Pour tous les motifs de test 11 à 17, la grandeur électrique dont on cherche à déterminer les grandeurs unitaires est mesurée dans des conditions identiques (polarisation en tension, température, etc.) de façon que les différences observées ne soient imputables qu'à un changement de géométrie. Par exemple, on pourra incorporer les quatre motifs de test décrits en figures 2A à 2D dans des émetteurs de transistors NPN verticaux et adopter le schéma illustré en figure 3 dans lequel chacun des motifs de test 11 à 17 est incorporé en tant que motif d'émetteur d'un transistor 21 à 27. Les émetteurs de ces transistors sont reliés ensemble et à la masse par l'intermédiaire d'une source de courant 30. Cette configuration permet d'assurer que les jonctions base-émetteur des 4 motifs soient polarisées :

- sous la même tension,
- à un niveau de courant total bien défini, imposé par la source de courant, tel que les chutes de tension dues aux résistances parasites d'accès aux jonctions soient négligeables. La polarisation des jonctions par une source de tension permettrait de garantir l'équipotentialité des jonctions base-émetteur, mais pas le niveau de courant. Tous les collecteurs de ces transistors sont reliés à la masse par l'intermédiaire d'ampèremètres 31,33,35,37. Des ampèremètres 32,34,36,38 sont destinés à contrôler le courant de base de chaque transistor.

Si l'on mesure tous les courants de collecteur, les relations entre les courants mesurés I1, I2, I3, I4 et les composantes élémentaires de courant peuvent être représentées simplement sous forme matricielle.

$$
\begin{bmatrix} I1 \\ I2 \\ I3 \\ I4 \end{bmatrix}
=
\begin{bmatrix}
4 & XD1 \times YD1 & 2YD1 & 2XD1 \\
4 & XD2 \times YD2 & 2YD2 & 2XD2 \\
4 & XD3 \times YD3 & 2YD3 & 2XD3 \\
4 & XD4 \times YD4 & 2YD4 & 2XD4
\end{bmatrix}
\times
\begin{bmatrix} Jcoin \\ JS \\ JPX \\ JPY \end{bmatrix}
$$

$$[I] = [G] \times [J],$$

où I est le courant de base ou de collecteur et J la densité de courant correspondante.

Dans cette équation, I1, I2, I3, I4 désignent les courants mesurés (I = IC ou IB).

Les différents éléments de la matrice G sont des coefficients pondérateurs associés aux flux élémentaires de courant collecteur ou base (coins, surface et périmètre en X et Y) ; ces valeurs sont connues d'après le dessin des masques.

Le vecteur J est le vecteur des densités de courant à déterminer. Jcoin est le flux associé à un coin, JS le flux de surface exprimé en ampères par micromètre$^2$, JPX et JPY sont les flux associés aux bords en X et Y, mesurés en ampères par micromètre.

Ces flux intègrent tous les effets de bords tels que la surgravure, la diffusion latérale, la variation d'épaisseur de base à la périphérie de l'émetteur. Ces effets de bord sont différents selon que l'on considère le courant de collecteur ou le courant de base.

Selon un avantage de la présente invention et en raison du choix particulier des dimensions des quatre rectangles, il n'est pas nécessaire d'inverser la matrice G. En effet, compte tenu du fait que XD1 = XD3, YD1 = YD2, XD2 = XD4 et YD3 = YD4, on obtient directement l'inconnu JS en décomposant le plus grand motif (figure 2D) en quatre régions dont trois sont communes aux motifs des figures 2A, 2B et 2C. Ainsi,

$$I4 - I3 - I2 + I1 = JS \times (SD4 - SD3 - SD2 + SD1)$$

avec SD1, SD2, SD3, SD4 : surfaces dessinées des quatre motifs.

Le flux unitaire de surface JS est obtenu facilement :
- sans connaissance a priori des écarts entre dimensions réelles et dessinées,
- en s'affranchissant des effets de coins.

JPX et JPY sont définis respectivement par les relations suivantes :

$$JPX = [I4 - I2 - JS \times (SD4 - SD2)]/[2 \times (YD4 - YD2)]$$
$$JPY = [I4 - I3 - JS \times (SD4 - SD3)]/[2 \times (XD4 - XD3)]$$

Jcoin est défini à partir de la mesure de I1 et des autres paramètres JS, JPX, JPY.

$$I1 = 4 \times Jcoin + 2 \, XD1 \, JPY + 2 \, YD1 \, JPX + XD1 \, YD1 \, JS$$

d'où :

$$Jcoin = 1/4 \, [I1 - 2 \, XD1 \, JPY - 2 \, YD1 \, JPX - XD1 \, YD1 \, JS]$$

Enfin, on détermine les écarts équivalents dX et dY entre dimensions réelles et dessinées séparément selon les axes X et Y.

Tout courant sans effet de coin s'exprime sous la forme :

$$I - 4 \, Jcoin = JS \times S + JPX \, 2XD + JPY \, 2YD$$
$$= JS \times S \, [1 + (JPX \, 2YD + JPY \, 2XD)/(JS \times S)]$$

Les écarts équivalents dX et dY sont définis en identifiant la relation précédente avec la relation suivante :

$$I - 4 \, Jcoin = JS \times [S + dX \times 2YD + dY \times 2XD]$$
$$= JS \times S \, [1 + dX \times (2YD/S) + dY \times (2XD/S)]$$

d'où :

$$dX = JPX/JS$$
$$dY = JPY/JS.$$

Ainsi, les avantages du procédé selon la présente inventions ont notamment les suivants :
- les grandeurs de surface et de périmètre sont déterminées à partir des grandeurs mesurées en ne faisant intervenir que des différences de cotes dessinées ;
- non seulement les écarts entre cotes réelles et cotes dessinées n'ont pas à être connus a priori, mais en plus on peut déterminer les paramètres associés équivalents :
  . sans faire d'hypothèse simplificatrice (telle que la non prise en compte des effets de coins),
  . séparément sur les axes X et Y,
  . localement sur la puce, d'où il résulte que l'on prend en compte la dispersion spatiale inévitable sur une plaquette donnée.
- si le motif I1 est dessiné conformément aux règles minimum du procédé de fabrication, les grandeurs électriques de tout nouveau composant peuvent être prévues par la superposition de grandeurs unitaires, ce qui permet d'optimiser le dessin du composant par rapport à la performance électrique attendue.

La grandeur électrique globale attendue est définie simplement par :

5

$$I - 4 \times Jcoin + 2JPX \times YD + 2JPY \times XD + JS \times XD \times YD$$

| Contribution | Contribution du | Contribution du | Contribution |
|---|---|---|---|
| des angles | périmètre en X | périmètre en Y | de surface |

ou bien :

$$I = I1 + 2\ JPX \times (YD-YD1) + 2\ JPY \times (XD-XD1) +$$
$$JS(XD \times YD-XD1 \times YD1)$$

| Contribution | Contribution | Contribution | Contribution |
|---|---|---|---|
| du motif 11 | du périmètre | du périmètre | de surface |
|  | en X (hors | en Y (hors | (hors motif 11) |
|  | motif 11) | motif 11) |  |

Le principe de la symétrie des motifs de la structure ainsi que le procédé de mesure sont applicables à l'évaluation de grandeurs de surface et de périmètre de tout type de composant telles que :

. les densités de courant des transistors bipolaires :
- de la jonction base/émetteur
- de la jonction base/collecteur,
. les longueurs et largeurs effectives des transistors MOS,
. les capacités d'oxyde ou de jonction,
. les résistances (puits collecteur vertical...).

Chaque fois qu'un phénomène physique peut se décrire sous la forme d'un flux de particules élémentaires à travers une surface plane dans un volume mince, associé à un flux périmétrique situé aux limites de cette surface, l'invention peut être utilisée.

Dans le domaine des semiconducteurs où les conditions de fabrication sont inévitablement dispersées, l'invention, de par sa souplesse de mise en oeuvre et sa précision, permet un suivi statistique des grandeurs électriques unitaires associées aux phénomènes physiques élémentaires que sont les flux de courant, ou de charges en corrélation étroite avec les conditions de fabrication.

Les figures 4A et 4B montrent mieux comment l'un des motifs de test, par exemple le motif I1, peut être inséré dans un transistor pour servir de test des caractéristiques de conduction orthogonalement à la surface d'une couche d'émetteur. La figure 4A représente un dessin de masque vu de dessus et la figure 4B est une vue en coupe de la structure correspondante. Ainsi, en figure 4A, des éléments indiqués par une référence impaire indiquent une ouverture de masque alors qu'en figure 4B, les zones désignées par une référence paire d'une unité supérieure à celle de la figure 4A indiquent les couches obtenues par le dessin de masque correspondant. Ainsi, l'ensemble de masques 21 représenté en figure 4A fournit la structure 22 de la figure 4B. La couche que l'on veut plus particulièrement tester est la couche d'émetteur 12 correspondant au dessin de masque 11.

Le transistor NPN 22 a été représenté dans le cadre d'une technologie particulière sur un substrat 40 de type P, les éléments actifs étant entourés d'une zone 42 de type P pour former des caissons d'une couche épitaxiée 44 de type N au fond desquels se trouve une couche enterrée 46 de type N$^+$. Dans cette couche enterrée sont successivement amenées à diffuser une région de base 48 et des régions d'émetteur et de collecteur 12 et 50. Enfin, des métallisations d'émetteur 52, de base 54 et de collecteur 56 sont formées sur les régions de contact correspondantes.

La conduction dans la couche d'émetteur 12 se fait perpendiculairement à la surface de cette couche vers la couche enterrée 46 puis vers la zone de contact de collecteur 50 et la métallisation de collecteur 56. Eventuellement, dans certaines techniques, un puit collecteur permet de rejoindre la couche enterrée 46.

Ainsi, selon la présente invention, on utilisera quatre transistors tels que celui représenté en figure 4A et 4B, les formes des émetteurs correspondant aux formes représentées en figures 2A à 2D.

Il convient de préciser que l'application particulière de la figure 3 et des figures 4A et 4B ne constitue qu'un exemple d'utilisation de la structure de test selon la présente invention. Au lieu de mesurer des passages de courant à travers des couches, on pourrait éventuellement envisager, par exemple pour tester des oxydes de grille dans des structures de type MOS, d'appliquer des différences de potentiel et d'effectuer des mesures de capacité. De même, on peut envisager des mesures en courant alternatif si cela s'avère souhaitable.

On trouvera ci-après des formules qui résument la façon dont on peut extraire des paramètres recherchés à partir des mesures effectuées sur des motifs de test selon l'invention, ainsi que les relations entre les incertitudes de mesure inévitables et les incertitudes finales sur les paramètres obtenus.

DENSITE DE COURANT DE SURFACE

JS = (I4 - I3 - I2 + I1) / (SD4 - SD3 - SD2 + SD1)
dJS/JS = (dI4 + dI3 + dI2 + dI1) / (I4 - I3 - I2 + I1)

DENSITE DE COURANT DE PERIMETRE EN X ET INCERTITUDE ABSOLUE

JPX = [I4 - I2 - JS x (SD4 - SD2)] / [2(YD4 - YD2)]
JPX = [(I4 - I2) (SD1 - SD3) + (I3-I1) (SD4 - SD2)] / [2 (YD4 - YD2) (SD4 - SD3 - SD2 + SD1)]
dJPX = [(dI4 + dI2) (SD3 - SD1) + (dI3 + dI1) (SD4 - SD2)] / [2 (YD4 - YD2) (SD4 - SD3 - SD2 + SD1)]

DENSITE DE COURANT DE PERIMETRE EN Y ET INCERTITUDE ABSOLUE

JPY = [I4 - I3 - JS x (SD4 - SD3)] / [2(XD4 - XD3)]
JPY = [(I4 - I3) (SD1 - SD2) + (I2 - I1) (SD4 - SD3)] / [2 (XD4 - XD3) (SD4 - SD3 - SD2 + SD1)]
dJPY = [(dI4 + dI3) (SD2 - SD1) + (dI2 - dI1) (SD4 - SD3)] / [2 (XD4 - XD3) (SD4 - SD3 - SD2 + SD1)]

DENSITE DE COURANT DE COIN ET INCERTITUDE ABSOLUE

Jcoin = 0,25 x [I1 - 2XD1 JPY - 2YD1 JPX - XD1 YD1 JS]
dJcoin = 0,25 x [dI1 x A1 + dI2 x A2 + dI3 x A3 + dI4 x A4]


avec :

A1 = [1 - SD1/(SD4 - SD3 - SD2 + SD1)]
A2 = YD1/(YD4 - YD2) + SD1/(SD4 - SD3 - SD2 + SD1)
A3 = XD1/(XD4 - XD3) + SD1/(SD4 - SD3 - SD2 + SD1)
A4 = XD1/(XD4 - XD3) + YD1/(YD4 - YD2) + SD1/(SD4-SD3-SD2+SD1)

EXTENSION DE SURFACE EQUIVALENTE EN X ET INCERTITUDE ABSOLUE

dX = JPX/JS
d(dX) = [(SD4-SD3-SD2+SD1) / 2(YD4-YD2)] x [1/(I4-I3-I2+I1)$^2$] x [(I3 - I1) (dI4 + dI2) + (I4 - I2) (dI1 + dI3)]

EXTENSION DE SURFACE EQUIVALENTE EN Y ET INCERTITUDE ABSOLUE

dy = JPY/JS
d(dY) = [(SD4-SD3-SD2+SD1) / 2(XD4-XD3)] x [1/(I4-I3-I2+I1)$^2$] x [(I2 - I1) (dI4 + dI3) + (I4 - I3) (dI1 + dI2)]

**Revendications**

**1.** Structure de test de circuit intégré pour déterminer l'incidence de divers effets de conduction dans des couches donnés du circuit intégré et séparer les effets de surface des effets de coin et de périmètre dans deux directions perpendiculaires dans laquelle des motifs de test de formes déterminées sont insérés dans des composants élémentaires comprenant lesdites couches polarisées dans le sens de leur épaisseur, caractérisée en ce qu'elle comprend quatre motifs de test (11, 13, 15, 17) correspon-

EP 0 299 887 B1

dant respectivement à quatre portions desdites couches délimitées selon quatre rectangles dont chacun se déduit des autres par une dimension commune et que ces quatre rectangles n'ont que deux dimensions de longueur (YD) et deux dimensions de largeur (XD).

2. Structure de test d'un couche de circuit intégré pour déterminer l'incidence du processus de fabrication sur des composants comprenant des parties de ladite couche dans laquelle, dans une zone de test, on forme quatre composants élémentaires comprenant chacun une portion de ladite couche, caractérisée en ce que, dans lesdits composants élémentaires de test, portions de ladite couche ont des formes rectangulaires dont chacune se déduit des autres par une dimension commune et que ces quatre rectangles n'ont que deux dimensions de longueur (YD) et deux dimensions de largeur (XD).

3. Procédé de test utilisant une structure de test selon l'une des revendications 1 et 2, caractérisé en ce qu'il comprend les étapes suivantes :
   - connecter ensemble à une première borne les premiers contacts des composants associés à une première face des motifs de test ;
   - connecter les autres contacts des composants associés à la deuxième face des motifs à une deuxième borne par l'intermédaire de moyens de mesure d'un paramètre électrique ;
   - appliquer entre les première et deuxième bornes une source d'alimentation électrique ;
   - mesurer les paramètres électriques fournis par la source d'alimentation ;
   - en déduire les effets de surface, de périmètre en X et en Y, et de coin.

**Claims**

1. A test structure in an integrated circuit for determining the incidence of various conduction effects on given layers of the integrated circuit and separating the surface effects from the wedge effects and periphery effects into two perpendicular directions, wherein test patterns of determined shapes are incorporated into elementary components comprising said layers transversely polarized, characterized in that it comprises four test patterns (11, 13, 15, 17) respectively corresponding to four portions of said layers delimited according to four rectangles, each of which is derived from the others by a common dimension, those four rectangles having only two length values (YD) and two width values (XD).

2. A test structure of integrated circuit layer for determining the incidence of the manufacturing process over components comprising portions of said layer wherein in a test area, one forms four elementary components each comprising one portion of said layer, characterized in that, in said elementary components, said portions of said layer have rectangular shapes, each of which is derived from the others by a common dimension, those four rectangles having only two length values (YD) and two width values (XD).

3. A test process using a test structure according to claim 1 or 2, characterized in that it comprises the following steps:
   - interconnecting with a first terminal the first contacts of the components associated with a first face of the test patterns;
   - connecting the other contacts of the components associated with the second face of the patterns with a second terminal through measurement means of an electrical parameter;
   - applying an electric supply source between said first and second terminals;
   - measuring the electrical parameters by said supply source;
   - deriving therefrom the surface, periphery in X and Y, and wedge effects.

**Patentansprüche**

1. Testanordnung für integrierte Schaltungen, um das Auftreten verschiedener Leitungseffekte in bestimmten Schichten der integrierten Schaltung zu bestimmen und um Oberflächeneffekte von Randeffekekten und Umfangseffekten in zwei senkrechten Richtungen zu separieren, wobei Testmuster bestimmter Formen in Elementarkomponenten eingefügt werden, die die erwähnten in Schichtdickenrichtung polarisierten Schichten enthalten, dadurch gekennzeichnet, daß die Anordnung vier Testmuster (11, 13, 15, 17) enthält, die vier Bereichen der Schichten entsprechen und durch vier Rechtecke bestimmt sind, die sich jeweils von anderen durch ein gemeinsames Maß ableiten, und daß die vier Rechtecke nur zwei Längenmaße (YD) und zwei Breitenmaße (XD) haben.

8

2. Testanordnung für eine Schicht einer integrierten Schaltung, um den Einfluß eines Herstellungsprozesses auf Komponenten zu bestimmen, die Teile dieser Schicht enthalten, worin in einer Testzone vier Elementarkomponenten gebildet werden, die jede einen Teil der Schicht umfassen, dadurch gekennzeichnet, daß in den elementaren Testkomponenten die Bereiche der Schicht rechteckige Formen haben, von denen jede sich aus den anderen durch ein gemeinsames Maß ableitet, und daß die vier Rechtecke nur zwei Längenmaße (YD) und zwei Breitenmaße (XD) haben.

3. Testverfahren, bei dem eine Testanordnung nach einem der Ansprüche 1 und 2 verwendet wird, dadurch gekennzeichnet, daß die folgenden Schritte vorgesehen sind:
   - die ersten Kontakte der Komponenten, die einer ersten Seite der Testmuster zugeordnet sind, werden gemeinsam mit einem ersten Anschluß verbunden;
   - die zweiten Kontakte der Komponenten, die der zweiten Seite der Testmuster zugeordnet sind, werden mit einem zweiten Anschluß über eine Meßeinrichtung für einen elektrischen Parameter verbunden;
   - Anlegen einer elektrischen Versorgungsquelle zwischen dem ersten und zweiten Anschluß;
   - Messen der von der Versorgungsquelle gelieferten elektrischen Parameter;
   - Ableiten daraus der Oberflächeneffekte, der Umfangseffekte in X und Y und der Randeffekte.

Fig. 1A

Fig.1B

Fig. 2A

Fig.2B

Fig. 2C

Fig. 2D

Fig. 3

Fig. 4A

Fig. 4B